# EUROPEAN PATENT SPECIFICATION

(11) **EP 3 816 682 B1**
(45) Date of publication and mention of the grant of the patent: **01.03.2023**
(21) Application number: 19823429.6
(22) Date of filing: 10.05.2019
(51) Int. Cl.: G02B 5/20, C04B 35/115, C04B 35/50, C04B 35/80, H01L 33/50, F21V 13/08, G02B 5/08, G02B 7/18

(54) **OPTICAL WAVELENGTH CONVERSION MEMBER, OPTICAL WAVELENGTH CONVERSION DEVICE, AND LIGHT EMITTING DEVICE**
OPTISCHES WELLENLÄNGENUMWANDLUNGSBAUTEIL, OPTISCHE WELLENLÄNGENUMWANDLUNGSVORRICHTUNG UND LICHTEMITTIERENDE VORRICHTUNG
PIÈCE DE CONVERSION DE LONGUEUR D'ONDE OPTIQUE, DISPOSITIF DE CONVERSION DE LONGUEUR D'ONDE OPTIQUE ET DISPOSITIF ÉLECTROLUMINESCENT

(30) Priority: 18.06.2018 JP 2018115578
(43) Date of publication of application: 05.05.2021
(73) Proprietor: NGK Spark Plug Co., Ltd., Nagoya-shi, Aichi 467-8525 (JP)
(72) Inventor: ITO, Tsuneyuki, Nagoya-shi, Aichi 467-8525 (JP); TAKAKU, Shohei, Nagoya-shi, Aichi 467-8525 (JP); SHIMURA, Yuki, Nagoya-shi, Aichi 467-8525 (JP); BAN, Shinji, Nagoya-shi, Aichi 467-8525 (JP); KATSU, Yusuke, Nagoya-shi, Aichi 467-8525 (JP)
(74) Representative: J A Kemp LLP
(86) International application number: PCT/JP2019/018819
(87) International publication number: WO 2019/244506

(56) References cited:
- WO-A1-2017/220411
- GB-A- 2 371 562
- JP-A- 2006 210 715
- JP-A- 2006 227 099
- JP-A- 2017 194 706
- JP-A- 2018 072 607
- JP-A- 2018 077 463
- US-A1- 2015 316 233
- US-A1- 2018 080 615
- US-B2- 7 189 460

## Description

This international application claims priority to Japanese Patent Application No. 2018-115578 filed in the Japan Patent Office on June 18, 2018.

The present disclosure relates to an optical wavelength conversion member, an optical wavelength conversion device, and a light-emitting device, each of which can convert light wavelength and is used for, for example, wavelength conversion apparatuses, fluorescent materials, lighting apparatuses, and video apparatuses.

A head lamp, a projector, a lighting apparatus, or a similar apparatus generally includes a device for achieving white light through wavelength conversion, by means of a fluorescent body, of blue light emitted from a light-emitting diode (LED) or a laser diode (LD).

Hitherto, the matrix or material of the fluorescent body (or a phosphor) is, for example, a resin material or a glass material. In accordance with a trend for using a high-output light source in recent years, the phosphor is required to have higher durability. Thus, ceramic phosphors (i.e., ceramic sintered bodies) have received attention.

Known ceramic phosphors are formed of a Ce-activated garnet (A₃B₅O₁₂) component, such as Y₃Al₅O₁₂:Ce (YAG:Ce) .

A known light-emitting member (i.e., an optical wavelength conversion member including a luminous body) used in the aforementioned lighting apparatus has a structure utilizing light reflected by a reflective layer provided in the member. Such a structure requires efficient reflection of blue light from a light source and light emitted from a phosphor. Thus, techniques for achieving such efficient reflection have been proposed (see Japanese Patent Application Laid-Open (kokai) No. 2016-58619 and Japanese Patent No. 6320531).

For example, Japanese Patent Application Laid-Open (kokai) No. 2016-58619 discloses a light-emitting device including a laser-excited ceramic phosphor, and a reflective layer having light reflectivity on a surface different from a laser irradiation surface.

Japanese Patent No. 6320531 discloses a composite product including a ceramic converter, a metal-containing reflective coating, and a metallic cooling body. In the composite product, the ceramic converter is covered directly with the metal-containing reflective coating.

US 2018/0080615 A1 discloses a fluorescence light source apparatus.

### PROBLEM TO BE SOLVED BY THE INVENTION

The aforementioned conventional techniques may cause problems as described below, and the techniques are required to be improved.

For example, the technique disclosed in Japanese Patent Application Laid-Open (kokai) No. 2016-58619 involves reflection of light by the reflective layer having light reflectivity. However, the technique may fail to extract light efficiently, since light reflection is based only on a metal component contained in the reflective layer.

The technique disclosed in Japanese Patent No. 6320531 involves reflection of light by the reflective coating layer covering the ceramic converter. However, similar to the case of the technique disclosed in Japanese Patent Application Laid-Open (kokai) No. 2016-58619, the technique may fail to extract light efficiently, since light reflection is based only on a metal component contained in the coating layer.

According to the present invention, there is provided an optical wavelength conversion member according to claim 1, an optical wavelength conversion device according to claim 8 , and a light-emitting device according to claim 9, each of which can achieve efficient light extraction.

### MEANS FOR SOLVING THE PROBLEM

(1) One aspect of the present disclosure is directed to an optical wavelength conversion member comprising a ceramic sintered body, wherein the ceramic sintered body has a fluorescent phase containing, as a main component, fluorescent crystal grains that generate fluorescence in response to incident light, and a translucent phase containing translucent crystal grains as a main component.

The optical wavelength conversion member further comprises a metal layer having light reflectivity and provided on a side of the ceramic sintered body opposite the side on which the light is incident, and a dielectric multilayer film including dielectric layers having different optical refractive indices and provided between the ceramic sintered body and the metal layer.

In the optical wavelength conversion member, the dielectric multilayer film including stacked dielectric layers having different optical refractive indices (i.e., a dielectric multilayer film capable of reflecting or transmitting light) is provided between the ceramic sintered body that generates fluorescence in response to incident light and the metal layer having light reflectivity (i.e., a reflective layer). Thus, the optical wavelength conversion member exhibits a higher reflectivity (i.e., reflectance) than a conventional optical wavelength converter including only a metal layer.

Thus, the optical wavelength conversion member can efficiently reflect incident light or fluorescence as compared with a conventional one. Therefore, the optical wavelength conversion member can achieve efficient light extraction, and thus exhibits high emission intensity (i.e., fluorescence intensity).

As used herein, the dielectric multilayer film refers to a layered product including dielectric films capable of transmitting light and having different optical refractive indices; i.e., a layered product having a structure wherein a high-refractive-index film and a low-refractive-index film (having a refractive index lower than that of the high-refractive-index film) are alternately stacked.

Examples of the material of the high-refractive-index film include niobium oxide (Nb₂O₅), titanium oxide (TiO₂), lanthanum oxide (La₂O₃), tantalum oxide (Ta₂O₅), yttrium oxide (Y₂O₃) , gadolinium oxide (Gd₂O₃), tungsten oxide (WO₃) , hafnium oxide (HfO₂) , aluminum oxide (Al₂O₃) , and silicon nitride (Si₃N₄). Examples of the material of the low-refractive-index film include silicon oxide (SiO₂). Thus, one mode of the dielectric multilayer film is, for example, a layered product composed of a titanium oxide layer and a silicon oxide layer.

The total number of films of the dielectric multilayer film may be two to four. Each film may have a thickness of 25 nm to 100 nm. The overall thickness of the dielectric multilayer film is preferably up to about 300 nm.

The ceramic sintered body preferably has a thickness of 100 µm to 400 µm.

The metal layer preferably has a thickness of, for example, 100 nm to 500 nm.

### <Principle of dielectric multilayer film>

Next will be described the reason why the intensity of reflected light is enhanced by the dielectric multilayer film. The reason will be briefly described, since it is based on a known principle.

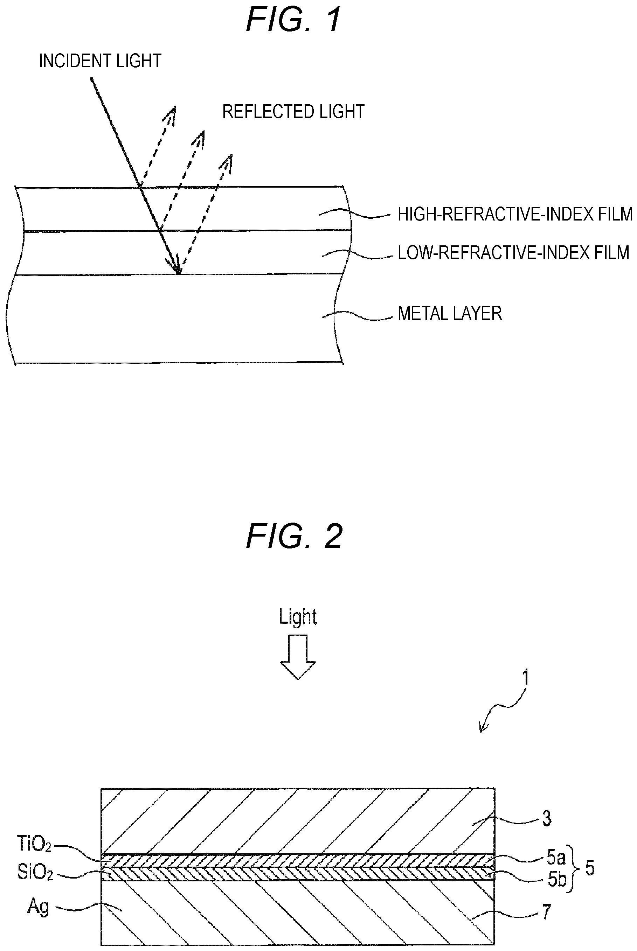

As shown in FIG. 1, when a high-refractive-index film and a low-refractive-index film are sequentially disposed from a light incident side; specifically, when a high-refractive-index film and a low-refractive-index film are sequentially disposed so as to have appropriate thicknesses with respect to a light wavelength λ, light reflected at the interface between the films is reinforced through interference.

Thus, when the thicknesses of a high-refractive-index film and a low-refractive-index film are determined so as to correspond to the wavelength of incident light, the intensity of reflected light can be enhanced. Therefore, the dielectric multilayer film of the present disclosure (including a high-refractive-index film and a low-refractive-index film) is formed so as to have a thickness that enables an increase in the intensity of reflected light in accordance with the wavelength of incident light.

When the intensity of reflected light is enhanced, a high-refractive-index film and a low-refractive-index film are sequentially disposed from a light incident side (the same shall apply in the case where a plurality of high-refractive-index films and low-refractive-index films are used).

In the aforementioned optical wavelength conversion member, the dielectric multilayer film has an overall thickness of 300 nm or less.

Because the overall thickness of the dielectric multilayer film is 300 nm or less, the residual stress applied to the dielectric multilayer film is reduced, and the adhesion between the dielectric multilayer film and the metal layer is less likely to be reduced.

(2) In the aforementioned optical wavelength conversion member, the crystal grains of the fluorescent phase may have a composition represented by formula A₃B₅O₁₂:Ce, and each of elements A and B may be at least one element selected from the following element groups:
A: Sc, Y, and lanthanoids exclusive of Ce, and
B: Al and Ga.

The expression "lanthanoids exclusive of Ce" refers to lanthanoids other than Ce.

In the optical wavelength conversion member, the ceramic sintered body has a garnet structure represented by A₃B₅O₁₂:Ce, wherein each of A and B is at least one element selected from the aforementioned element groups. This structure enables efficient conversion of blue light into visible light.

Use of the aforementioned ceramic sintered body can cause light scattering at the interface between the fluorescent phase and the translucent phase, thereby reducing the angular dependence of the color of light, leading to an improvement in color uniformity (i.e., reduction in color unevenness).

Also, use of the aforementioned ceramic sintered body, which exhibits high thermal conductivity, can efficiently dissipate heat generated in the ceramic sintered body by light (e.g., laser light) to the outside (e.g., a metal layer or a heat dissipation member), thereby preventing temperature quenching (i.e., no generation of fluorescence by the ceramic sintered body). Thus, even when high-output laser light is incident on the optical wavelength conversion member, fluorescence can be maintained at an appropriate level.

The amount of the compound having a composition represented by formula A₃B₅O₁₂:Ce is preferably 3 vol.% to 70 vol.% relative to the entire ceramic sintered body. In the compound having a composition represented by the aforementioned formula, the Ce concentration is preferably 0.1 mol% to 1.0 mol% relative to the element A of the compound. When the element A contains Gd, the Gd concentration is preferably 30 mol% or less relative to the entirety of element A. When the element B contains Ga, the Ga concentration is preferably 30 mol% or less relative to the entirety of element B.

(3) In the aforementioned optical wavelength conversion member, the crystal grains of the translucent phase may have a composition of Al₂O₃.

This is an example of preferred compositions of the crystal grains of the translucent phase.

(4) In the aforementioned optical wavelength conversion member, the metal layer may contain Ag and/or Al as a component.

When the component of the metal layer is Ag and/or Al, the metal layer effectively reflects light, such as externally incident light or fluorescence generated in the ceramic sintered body.

The metal layer is preferably, for example, an Ag layer or an Al layer.

The metal layer may be provided with a coating layer formed of alumina (Al₂O₃) on a side opposite the light incident side.

For example, when the metal layer is formed of Ag, exposed Ag may be oxidized, resulting in poor reflectivity. Thus, oxidation of Ag can be prevented by coating (i.e., covering) the surface of the Ag layer with alumina.

The alumina layer preferably has a thickness of about 30 nm to about 200 nm. A thickness exceeding this range may cause poor heat dissipation from the metal layer, thereby failing to achieve heat release.

(5) In the aforementioned optical wavelength conversion member, an Ni layer and/or an Au layer may be further provided on a side of the metal layer opposite the light incident side.

When the metal layer has, for example, an Au layer on a side opposite the light incident side, the Au layer provided on the metal layer can be strongly joined to a heat dissipation member (i.e., high bonding strength is achieved) by means of, for example, soldering.

When the metal layer has an Ag layer, and the Ag layer is provided with, for example, an Ni layer on a side opposite the light incident side, oxidation of Ag can be effectively prevented with the Ni layer.

When the aforementioned alumina coating layer is provided, the coating layer may be provided with an Ni layer and/or an Au layer on a side opposite the light incident side.

(6) In the aforementioned optical wavelength conversion member, the dielectric multilayer film may be formed by alternate stacking of a high-refractive-index film that exhibits a refractive index "a" upon incidence of light having a wavelength of 550 nm and a low-refractive-index film that exhibits a refractive index "b" upon incidence of light having a wavelength of 550 nm, the refractive index b being lower than the refractive index a, wherein the refractive index a and the refractive index b may satisfy a relation of 1.3 < a/b, and a relation of 1 < a/c may be satisfied wherein c represents the refractive index of the ceramic sintered body upon incidence of light having a wavelength of 550 nm on the ceramic sintered body.

When the aforementioned refractive indices a, b, and c satisfy the relations of 1.3 < a/b and 1 < a/c, the metal layer exhibits improved light reflectivity. Thus, light can be efficiently extracted from the optical wavelength conversion member.

As used herein, the expression "alternate stacking of a high-refractive-index film and a low-refractive-index film" refers to the case where a high-refractive-index film and a low-refractive-index film are stacked so as to be adjacent to each other. Thus, the dielectric multilayer film may be formed of one high-refractive-index film and one low-refractive-index film. Alternatively, the dielectric multilayer film may be formed of a plurality of stacked composite layers each including one high-refractive-index film and one low-refractive-index film.

(7) In the aforementioned optical wavelength conversion member, the high-refractive-index film may contain at least one element selected from among Ti, Zr, Hf, Ta, and Nb, and the low-refractive-index film may be formed of SiO₂ or MgF₂.

When the material of the high-refractive-index film contains at least one element selected from among Ti, Zr, Hf, Ta, and Nb (e.g., when the material is such an element), and the material of the low-refractive-index film is SiO₂ or MgF₂, light can be efficiently extracted from the optical wavelength conversion member.

(8) Another aspect of the present disclosure is directed to an optical wavelength conversion device comprising the aforementioned optical wavelength conversion member.

The optical wavelength conversion device comprises a heat dissipation member joined to the metal layer of the optical wavelength conversion member on a side opposite the light incident side.

Thus, the optical wavelength conversion device exhibits improved heat dissipation by virtue of the heat dissipation member, thereby preventing temperature quenching (i.e., no generation of fluorescence by the ceramic sintered body in association with an increase in the temperature of the ceramic sintered body).

The material for bonding the heat dissipation member to the optical wavelength conversion member may be a metallic material (e.g., solder) or a well-known thermally conductive adhesive having superior thermal conductivity.

The "heat dissipation member" as used herein refers to a member having heat dissipation (i.e., thermal conductivity) superior to that of the ceramic sintered body. The heat dissipation member may be any metal member formed of, for example, aluminum or copper.

(9) Still another aspect of the present disclosure is directed to a light-emitting device comprising the aforementioned optical wavelength conversion device and a light-emitting element.

The light (i.e., fluorescence) having a wavelength converted by means of the light-emitting device (specifically, the optical wavelength conversion member) exhibits high fluorescence intensity and high color uniformity.

The light-emitting element of the light-emitting device may be any known element, such as an LED or LD.

### <Characteristic features of the present disclosure will now be described>

The term "fluorescent phase" refers to a phase containing fluorescent crystal grains as a main component, and the term "translucent phase" refers to a phase containing, as a main component, translucent crystal grains; specifically, crystal grains having a composition different from that of the crystal grains of the fluorescent phase.

The term "main component" refers to any component present in a predominant amount (i.e., volume) in the aforementioned optical wavelength conversion member. For example, the fluorescent phase may contain fluorescent crystal grains in an amount of 50 vol.% or more (preferably 90 vol.% or more). For example, the translucent phase may contain translucent crystal grains in an amount of 50 vol.% or more (preferably 90 vol.% or more).

In the ceramic sintered body, crystal grains or the grain boundary therebetween may contain an unavoidable impurity. The ceramic sintered body may contain a fluorescent phase and a translucent phase (i.e., fluorescent crystal grains and translucent crystal grains) in an amount of 50 vol.% or more (preferably 90 vol.% or more) relative to the entire ceramic sintered body.

In the ceramic sintered body, the amount of the fluorescent phase (i.e., the amount of fluorescent crystal grains) may be 3 to 70 vol.%, whereas the amount of the translucent phase (i.e., the amount of translucent crystal grains) may be 30 to 97 vol.%

The term "A₃B₅O₁₂:Ce" refers to the case where a portion of the element A contained in A₃B₅O₁₂ is substituted by Ce through formation of a solid solution. The compound having such a structure exhibits fluorescent characteristics.
[FIG. 1] Explanatory view showing a principle of increasing the intensity of reflected light by means of a dielectric multilayer film.
[FIG. 2] Cross-sectional view (in a thickness direction) of an optical wavelength conversion member of a first embodiment.
[FIG. 3] Explanatory view showing a production process for the optical wavelength conversion member of the first embodiment.
[FIG. 4] Cross-sectional view (in a thickness direction) of an optical wavelength conversion member of a second embodiment.
[FIG. 5] Cross-sectional view (in a thickness direction) of an optical wavelength conversion member of a third embodiment.
[FIG. 6] Cross-sectional view (in a thickness direction) of an optical wavelength conversion member of a fourth embodiment.
[FIG. 7] Cross-sectional view (in a thickness direction) of an optical wavelength conversion member of a fifth embodiment.
[FIG. 8] Cross-sectional view (in a thickness direction) of an optical wavelength conversion member of a sixth embodiment.
[FIG. 9] Explanatory view showing a light-emitting device of an eighth embodiment.

### DESCRIPTION OF REFERENCE NUMERALS

1: optical wavelength conversion member
3: ceramic sintered body
7: metal layer
5: dielectric multilayer film
5a: high-refractive-index film
5b: low-refractive-index film
23: Ni layer
43: Au layer
51: optical wavelength conversion device
61: light-emitting device
63: light-emitting element

Next will be described embodiments of the optical wavelength conversion member, optical wavelength conversion device, and light-emitting device of the present disclosure.

### [1. First embodiment]

### [1-1. Structure of optical wavelength conversion member]

Now will be described the structure of an optical wavelength conversion member of the first embodiment.

As shown in FIG. 2, the optical wavelength conversion member 1 of the present embodiment is a plate-like member formed by sequential stacking of a plate-like ceramic sintered body 3, a dielectric multilayer film 5, and a metal layer 7 from the upper side of FIG. 2 (i.e., the side on which external light is incident). Hereinafter, the side on which light is incident (the upper side of FIG. 2) will be referred to as "incident side," and the side on which incident light is reflected (i.e., the side opposite the incident side; the lower side of FIG. 2) will be referred to as "reflection side."

Details will be described below.

### <Ceramic sintered body>

The ceramic sintered body 3 is a fluorescent body composed of a fluorescent phase containing, as a main component, crystal grains that generate fluorescence in response to externally incident light (i.e., fluorescent phase grains), and a translucent phase containing, as a main component, translucent crystal grains (i.e., translucent phase grains).

Thus, the ceramic sintered body 3 is composed of a fluorescent phase (cluster) containing one or more fluorescent phase grains, and a translucent phase (cluster) containing one or more translucent phase grains.

Thus, the ceramic sintered body 3 is substantially composed of fluorescent phase grains and fluorescent phase grains. The amount of fluorescent phase grains and fluorescent phase grains contained in the ceramic sintered body 3 is, for example, 90 vol.% or more (e.g., about 100 vol.*%*).

Specifically, the fluorescent phase grains have a composition represented by formula A₃B₅O₁₂:Ce, and each of elements A and B is at least one element selected from the following element groups:
A: Sc, Y, and lanthanoids exclusive of Ce, and
B: Al and Ga.

A and B of formula A₃B₅O₁₂:Ce are elements (different elements) of a substance represented by formula A₃B₅O₁₂:Ce. In formula A₃B₅O₁₂:Ce, O is oxygen and Ce is cerium.

In the ceramic sintered body 3, the amount of the compound (i.e., fluorescent phase grains) having a composition represented by formula A₃B₅O₁₂:Ce is, for example, 3 vol.% to 70 vol.% relative to the entire ceramic sintered body 3.

In the fluorescent phase grains, the Ce concentration is, for example, 0.1 mol*%* to 1.0 mol*%* relative to the element A of the compound.

When the element A contains Gd, the Gd concentration is, for example, 30 mol*%* or less relative to the entirety of element A. When the element B contains Ga, the Ga concentration is, for example, 30 mol*%* or less relative to the entirety of element B.

The translucent phase grains have a composition of, for example, Al₂O₃.

The ceramic sintered body 3 has dimensions of, for example, 10 mm (width) × 10 mm (length), and a thickness of, for example, 100 µm to 400 µm (e.g., 100 µm) .

### <Dielectric multilayer film>

The dielectric multilayer film 5 includes a plurality of dielectric layers having different optical refractive indices and can transmit light.

Thus, the dielectric multilayer film 5 is a layered product including dielectric films having different optical refractive indices; i.e., a layered product including a high-refractive-index film and a low-refractive-index film (having a refractive index lower than that of the high-refractive-index film).

Specifically, as shown in FIG. 2, the dielectric multilayer film 5 is, for example, a layered product including a TiO₂ film (i.e., high-refractive-index film) 5a disposed on the light incident side and an SiO₂ film (i.e., low-refractive-index film) 5b disposed on the reflection side.

In the present embodiment, the total number of layers (films) of the dielectric multilayer film 5 is two. However, the total number of layers may be, for example, two to four. Each of the TiO₂ film 5a and the SiO₂ film 5b may have, for example, 25 nm to 100 nm. The overall thickness of the dielectric multilayer film 5 is up to 300 nm.

As described above, when the thicknesses of the high-refractive-index film and the low-refractive-index film are determined so as to correspond to the wavelength of incident light, the intensity of reflected light can be enhanced. Therefore, the thicknesses of the TiO₂ film 5a and the SiO₂ film 5b are determined so that the intensity of reflected light can be enhanced in accordance with the wavelength λ of incident light.

When the wavelength of incident light is, for example, 465 nm, the thickness of each of the TiO₂ film 5a and the SiO₂ film 5b is preferably 50 nm.

### <Metal layer>

The metal layer 7 is formed of a metal having light reflectivity.

In the present embodiment, the metal layer 7 has a structure including, for example, a single layer of Ag (Ag layer). However, the metal layer 7 may be formed of a layer of another metal (e.g., Al).

Alternatively, the metal layer 7 may have a multilayer structure including layers of different metals (e.g., an Ag layer and an Al layer).

The metal layer 7 may have a thickness of, for example, 100 nm to 500 nm.

### [1-2. Production method for optical wavelength conversion member]

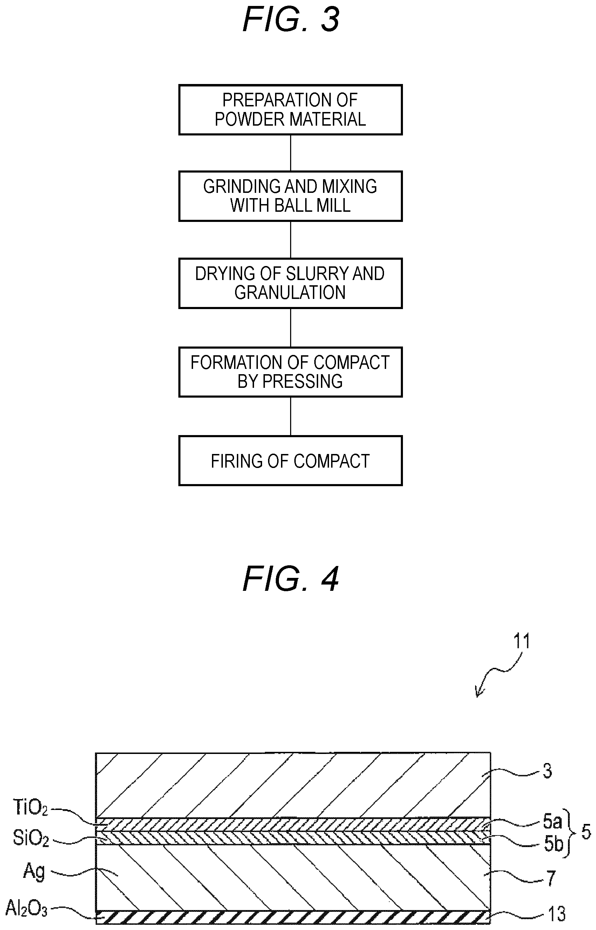

A schematic production process for the optical wavelength conversion member 1 will now be briefly described with reference to FIG. 3.

Firstly, powder materials of the ceramic sintered body 3 were weighed so as to satisfy the aforementioned requirement of the first embodiment and subjected to another process (i.e., the powder materials were prepared).

Subsequently, an organic solvent and a dispersant were added to the prepared powder materials, and these materials were grind-mixed in a ball mill, to thereby prepare a slurry.

The slurry was then dried and formed into granules.

The resultant granules were then subjected to press molding.

The resultant pressed compact was then fired at a predetermined temperature for a predetermined period of time, to thereby produce the ceramic sintered body 3.

Instead of the aforementioned production method for the ceramic sintered body 3 by press molding, the ceramic sintered body 3 may be produced by firing of a sheet compact prepared through sheet molding of the slurry.

Subsequently, the dielectric multilayer film 5 was formed on one surface (on the reflection side) of the ceramic sintered body 3 in a thickness direction.

Specifically, the TiO₂ film 5a was firstly formed by vacuum vapor deposition. Thereafter, the SiO₂ film 5b was formed on a surface (i.e., an exposed surface on the reflection side) of the TiO₂ film 5a by vacuum vapor deposition.

Subsequently, the metal layer (e.g., Ag layer) 7 was formed on a surface (i.e., an exposed surface on the reflection side) of the SiO₂ film 5b of the dielectric multilayer film 5 by, for example, vacuum vapor deposition.

The metal layer 7 may be formed by any thin film formation technique other than vacuum vapor deposition (e.g., sputtering or plating).

Thus, the optical wavelength conversion member 1 was produced.

### [1-3. Effects]

The effects of the first embodiment will next be described.
(1) The optical wavelength conversion member 1 of the first embodiment includes the metal layer (Ag layer) 7 having light reflectivity and provided on the side of the ceramic sintered body 3 opposite the side on which light is incident, and the dielectric multilayer film 5 including dielectric layers having different optical refractive indices and provided between the ceramic sintered body 3 and the metal layer 7.

The dielectric multilayer film 5 has a structure including the high-refractive-index film 5a and the low-refractive-index film 5b that are sequentially stacked from the light incident side. Light reflected at the interface between the films 5a and 5b is reinforced by interference.

According to this structure, the optical wavelength conversion member 1 exhibits a higher reflectivity (i.e., reflectance) than a conventional optical wavelength converter including only a metal layer. Accordingly, the optical wavelength conversion member 1 can efficiently reflect incident light or fluorescence as compared with a conventional one. Therefore, the optical wavelength conversion member 1 can achieve efficient light extraction, and thus exhibits high emission intensity (i.e., fluorescence intensity).

(2) In the first embodiment, the crystal grains of the fluorescent phase have a composition represented by formula A₃B₅O₁₂:Ce, and each of elements A and B is at least one element selected from the following element groups.
A: Sc, Y, and lanthanoids exclusive of Ce, and
B: Al and Ga.

This composition enables efficient conversion of blue light into visible light. Use of the ceramic sintered body 3 can cause light scattering at the interface between the fluorescent phase and the translucent phase, thereby reducing the angular dependence of the color of light, leading to an improvement in color uniformity (i.e., reduced color unevenness).

Also, use of the ceramic sintered body 3, which exhibits high thermal conductivity, can efficiently dissipate heat generated in the optical wavelength conversion member 1 by light (e.g., laser light) to the outside (e.g., the metal layer 7 or the heat dissipation member), thereby preventing temperature quenching (i.e., no generation of fluorescence by the ceramic sintered body 3). Thus, even when high-output laser light is incident on the optical wavelength conversion member 1, fluorescence can be maintained at an appropriate level.

(3) In the first embodiment, the metal layer 7 is formed of Ag. Thus, the metal layer 7 effectively reflects light, such as externally incident light or fluorescence generated in the ceramic sintered body 3. The metal layer 7 may be, for example, an Al layer instead of an Ag layer.

### [2. Second embodiment]

Next will be described an optical wavelength conversion member of a second embodiment. Description of the same components as those in the first embodiment is omitted or simplified. The same components as those in the first embodiment are denoted by the same reference numerals.

As shown in FIG. 4, the optical wavelength conversion member 11 of the second embodiment has a structure similar to that in the first embodiment; specifically, a structure formed by sequential stacking of a ceramic sintered body 3, a dielectric multilayer film 5 including a TiO₂ film 5a and an SiO₂ film 5b, and a metal layer (i.e., Ag layer) 7 from the upper side (incident side) of FIG. 4.

Particularly in the second embodiment, an Al₂O₃ layer 13 is formed on the reflection side (the lower side of FIG. 4) of the Ag layer 7 so as to cover the entire surface of the Ag layer 7. The Al₂O₃ layer 13 has a thickness of, for example, 30 nm to 200 nm.

The Al₂O₃ layer 13 can be formed by, for example, vacuum vapor deposition.

The second embodiment achieves the same effects as in the first embodiment. Since the surface of the Ag layer 7 is covered with the Al₂O₃ layer 13 in the second embodiment, oxidation of Ag can be prevented. Thus, deterioration of the reflectivity of the Ag layer 7 can be prevented.

The Ag layer 7 may be replaced for an Al layer. The Ag layer 7 and an Al layer may be stacked together (the same shall apply hereinafter).

### [3. Third embodiment]

Next will be described an optical wavelength conversion member of a third embodiment. Description of the same components as those in the first embodiment is omitted or simplified. The same components as those in the first embodiment are denoted by the same reference numerals.

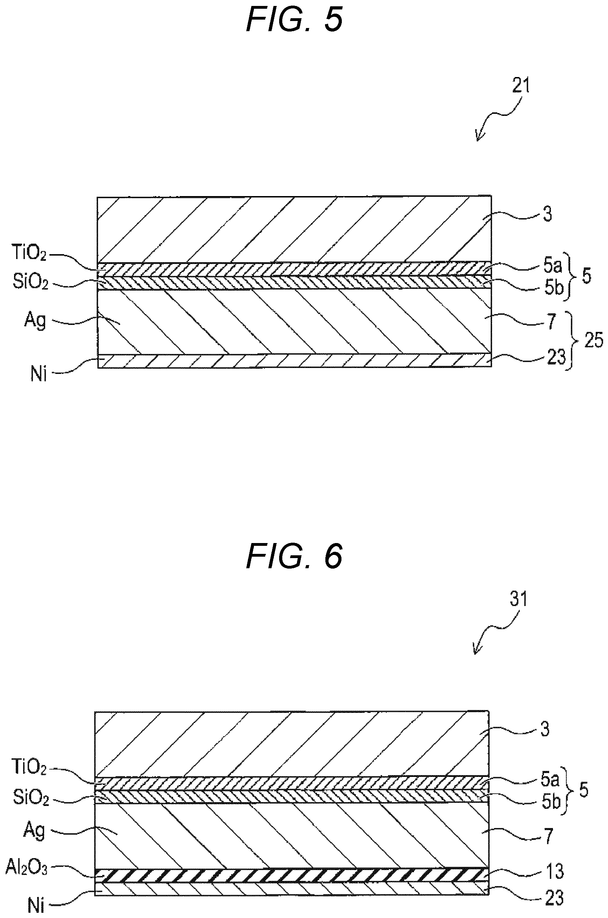

As shown in FIG. 5, the optical wavelength conversion member 21 of the third embodiment has a structure similar to that in the first embodiment; specifically, a structure formed by sequential stacking of a ceramic sintered body 3, a dielectric multilayer film 5 including a TiO₂ film 5a and an SiO₂ film 5b, and a metal layer (i.e., Ag layer) 7 from the upper side (incident side) of FIG. 5.

Particularly in the third embodiment, an Ni layer 23 is formed on the reflection side (the lower side of FIG. 5) of the Ag layer 7 so as to cover the entire surface of the Ag layer 7. The Ni layer 23 has a thickness of, for example, 100 nm.

When the surface of the Ag layer 7 is covered with another metal layer (e.g., the Ni layer 23), the structure including the Ag layer (i.e., metal layer) 7 and another metal layer (e.g., the Ni layer 23) will be referred to as "metal coating 25."

Similar to the case of the Ag layer 7, the Ni layer 23 can be formed by any thin film formation technique such as vacuum vapor deposition, sputtering, or plating.

The third embodiment achieves the same effects as in the first embodiment. Since the surface of the Ag layer 7 is covered with the Ni layer 23 in the third embodiment, oxidation of Ag can be prevented.

### [4. Fourth embodiment]

Next will be described an optical wavelength conversion member of a fourth embodiment. Description of the same components as those in the second embodiment is omitted or simplified. The same components as those in the second embodiment are denoted by the same reference numerals.

As shown in FIG. 6, the optical wavelength conversion member 31 of the fourth embodiment has a structure similar to that in the second embodiment; specifically, a structure formed by sequential stacking of a ceramic sintered body 3, a dielectric multilayer film 5 including a TiO₂ film 5a and an SiO₂ film 5b, a metal layer (i.e., Ag layer) 7, and an Al₂O₃ layer 13 from the upper side (incident side) of FIG. 6.

Particularly in the fourth embodiment, an Ni layer 23 (as in the case of the third embodiment) is formed on the reflection side (the lower side of FIG. 6) of the Al₂O₃ layer 13 so as to cover the entire surface of the Al₂O₃ layer 13.

The fourth embodiment achieves the same effects as in the first embodiment. Since the surface of the Ag layer 7 is covered with the Al₂O₃ layer 13 and the Ni layer 23 in the fourth embodiment, oxidation of Ag can be effectively prevented.

### [5. Fifth embodiment]

Next will be described an optical wavelength conversion member of a fifth embodiment. Description of the same components as those in the third embodiment is omitted or simplified. The same components as those in the third embodiment are denoted by the same reference numerals.

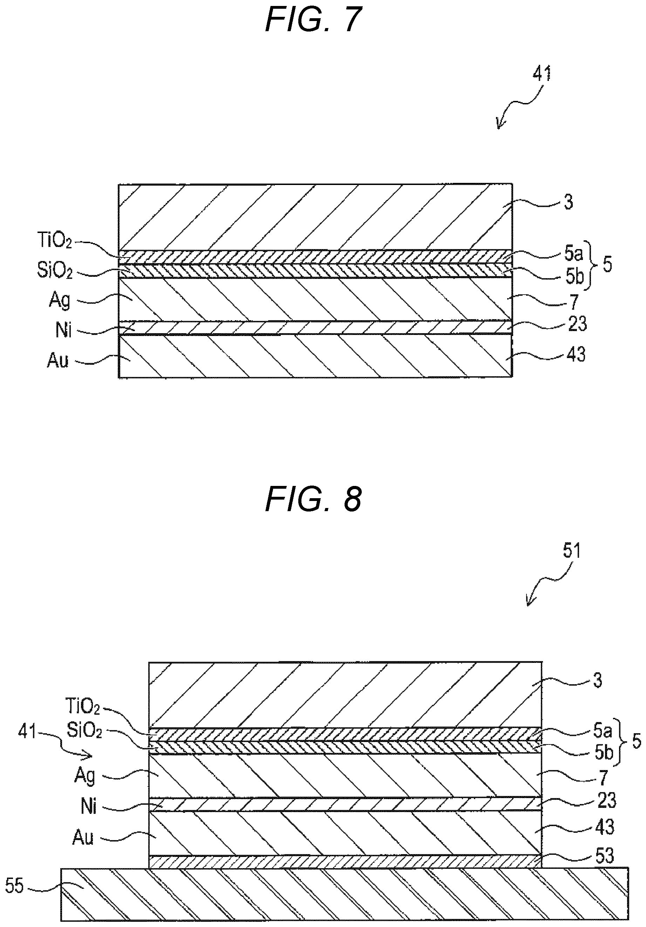

As shown in FIG. 7, the optical wavelength conversion member 41 of the fifth embodiment has a structure similar to that in the third embodiment; specifically, a structure formed by sequential stacking of a ceramic sintered body 3, a dielectric multilayer film 5 including a TiO₂ film 5a and an SiO₂ film 5b, a metal layer (i.e., Ag layer) 7, and an Ni layer 23 from the upper side (incident side) of FIG. 7.

Particularly in the fifth embodiment, an Au layer 43 is formed on the reflection side (the lower side of FIG. 7) of the Ni layer 23 so as to cover the entire surface of the Ni layer 23. The Au layer 43 has a thickness of, for example, 200 nm.

Similar to the case of the Ni layer 23, the Au layer 43 can be formed by any thin film formation technique such as vacuum vapor deposition, sputtering, or plating.

The fifth embodiment achieves the same effects as in the third embodiment. Since the surface of the Ag layer 7 is covered with the Ni layer 23 and the Au layer 43 in the fifth embodiment, oxidation of Ag can be effectively prevented.

The Ag layer 7 may be replaced for an Al layer, and the Au layer 43 may be replaced for an Ag layer. In addition, an Al₂O₃ layer 13 (as in the case of the fourth embodiment) may be provided between the Ag layer 7 and the Ni layer 23.

### [6. Sixth embodiment]

Next will be described an optical wavelength conversion member of a sixth embodiment. Description of the same components as those in the fifth embodiment is omitted or simplified. The same components as those in the fifth embodiment are denoted by the same reference numerals.

As shown in FIG. 8, the optical wavelength conversion member 51 of the sixth embodiment includes an optical wavelength conversion member 41 (as in the case of the fifth embodiment), and a plate-like heat dissipation member 55 joined to the optical wavelength conversion member 41 on the reflection side (the lower side of FIG. 8) via a bonding member 53 formed of a bonding material.

The optical wavelength conversion member 41 has a structure similar to that in the fifth embodiment; specifically, a structure formed by sequential stacking of a ceramic sintered body 3, a dielectric multilayer film 5 including a TiO₂ film 5a and an SiO₂ film 5b, a metal layer (i.e., Ag layer) 7, an Ni layer 23, and an Au layer 43 from the upper side (incident side) of FIG. 8.

The bonding member 53 is formed of a bonding material having high thermal conductivity; for example, a metal bonding material such as solder containing Pb. The bonding member 53 may be formed of, besides a metal bonding material, a well-known thermally conductive adhesive having high thermal conductivity.

The heat dissipation member 55 has an outer size larger than that of the optical wavelength conversion member 41 in plan view (as viewed in a vertical direction of FIG. 8). When the optical wavelength conversion member 41 has dimensions of, for example, 3.5 mm (length) × 3.5 mm (width) × 100 µm (thickness), the heat dissipation member may have dimensions of, for example, 12 mm (length) × 12 mm (width) × 1.5 mm (thickness).

The heat dissipation member 55 has higher heat dissipation (i.e., thermal conductivity) than the ceramic sintered body 3. The heat dissipation member 55 may be formed of, for example, a metal such as aluminum or copper.

Although not illustrated, a protective layer may be formed between the optical wavelength conversion member 41 and the bonding member 53 for improving bonding property. The protective layer may be an Ni sheet.

The sixth embodiment achieves the same effects as in the fifth embodiment. In the sixth embodiment, high heat dissipation is achieved, since the optical wavelength conversion member 41 is joined to the heat dissipation member 55. Thus, since an increase in the temperature of the ceramic sintered body 3 can be reduced, temperature quenching can be prevented, thereby achieving superior emission property (i.e., fluorescence property).

### [7. Seventh embodiment]

Next will be described a light-emitting device of a seventh embodiment. Description of the same components as those in the sixth embodiment is omitted or simplified. The same components as those in the sixth embodiment are denoted by the same reference numerals.

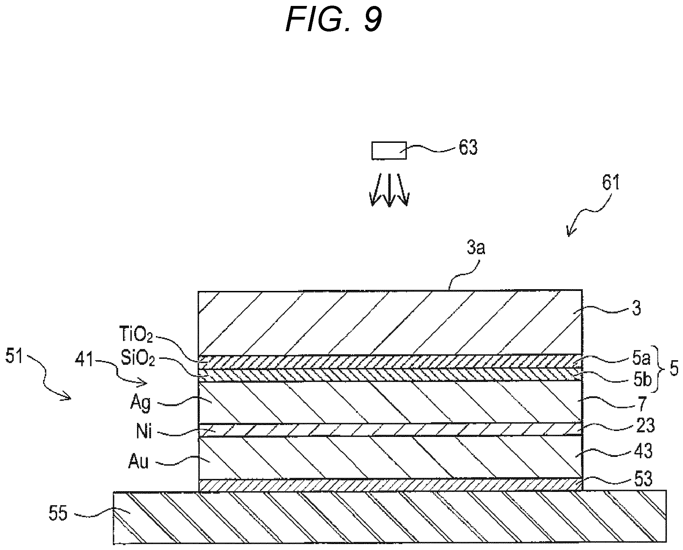

As shown in FIG. 9, the light-emitting device 61 of the seventh embodiment includes a light-emitting element 63 disposed on the incident side (upper side of FIG. 9) of an optical wavelength conversion member 51 similar to that of the sixth embodiment.

The light-emitting element 63 may be any known element such as an LED or LD.

In the light-emitting device 61, blue light is emitted from the light-emitting element 63 onto the surface of the ceramic sintered body 3. The light undergoes wavelength conversion in the ceramic sintered body 3 and is reflected by, for example, the Ag layer 7. Consequently, white light (resulting from mixing of different colors of light) is emitted through the upper surface of the optical wavelength conversion member 41 (i.e., the upper surface 3a of the ceramic sintered body) toward the upper side of FIG. 9.

The seventh embodiment achieves the same effects as in the sixth embodiment. The light-emitting device 61 of the seventh embodiment can emit light of high intensity to the outside.

### [8. Examples]

The aforementioned embodiments will next be described in detail by way of specific working examples.

There were prepared optical wavelength conversion members (samples Nos. 1 to 18) shown in Table 1 below.

Samples Nos. 1 to 6 and 10 to 17 10 fall within the scope of the present invention, and samples Nos. 7 to 9 and 18 fall outside the scope of the present invention

### (Comparative Examples).

The optical wavelength conversion member having the same structure as in the third embodiment was used as the optical wavelength conversion member of the present disclosure. Specifically, there was used a structure formed by stacking of a ceramic sintered body, a dielectric multilayer film, an Ag layer, and an Ni layer. In the column "Dielectric multilayer film" of Table 1, the structure of a dielectric multilayer film corresponding to each sample nearer to the ceramic sintered body is placed in the left.

### [8-1. Evaluation of samples]

As described below, the samples were evaluated for the following items.

### <Relative density>

The open porosity of the ceramic sintered body of the optical wavelength conversion member of each sample was measured by the method according to JIS R1634. The measured value was used to determine the relative density of the ceramic sintered body.

### <Laser output resistance>

Blue LD light having a wavelength of 465 nm was focused to a width of 0.1 mm by means of a lens, and the optical wavelength conversion member of each sample was irradiated with the focused light. Reflected light was focused with a lens, and the chromaticity (X) of the focused light was measured by means of a spectroradiometer (CL-500A, manufactured by KONICA MINOLTA, INC.). The sample was irradiated with the light at a power density of 0 to 100 W/mm².

Occurrence of temperature quenching was determined when the chromaticity was reduced to 60% or less of that at a laser power density of 5 W/mm². The laser power density at occurrence of temperature quenching is shown in Table 1 below. The ">100" shown in Table 1 corresponds to no temperature quenching even at 100 W/mm². A sample exhibiting no temperature quenching at 100 W/mm² or more is preferred in terms of laser output resistance.

### <Fluorescence intensity>

Blue LD light having a wavelength of 465 nm was focused to a width of 0.1 mm by means of a lens, and the optical wavelength conversion member of each sample was irradiated with the focused light. Reflected light was focused with a lens, and the emission intensity (i.e., fluorescence intensity) was measured by means of a power sensor. The sample was irradiated with the light at a power density of 40 W/mm². The fluorescence intensity of each sample was compared with that (taken as 100%) in the case where a single-crystal body (i.e., a YAG:Ce single-crystal body) was used as the ceramic sintered body (fluorescent body). The fluorescence intensity is preferably 100% or more.

### <Color unevenness>

Color unevenness (variation in color) was evaluated through determination of a variation in chromaticity by means of an illuminometer.

Specifically, blue LD light having a wavelength of 465 nm was focused to a width of 0.5 mm by means of a lens, and the optical wavelength conversion member of each sample was irradiated with the focused light. The chromaticity of reflected light was measured by means of a spectroradiometer (CL-500A, manufactured by KONICA MINOLTA, INC.).

The light irradiation was performed on a 9 mm square region (divided into nine regions at intervals of 3 mm) at the center of the surface of each sample (i.e., sample surface). A variation in chromaticity (in X-direction) (i.e., Δx) was evaluated in each of the nine regions. As used herein, the term "variation in chromaticity (Δx)" refers to the maximum deviation of chromaticity (in X-direction). The variation in chromaticity Δx is preferably less than 0.03.

The term "chromaticity" as used herein refers to a chromaticity indicated by the CIE-XYZ color system established by the International Commission on Illumination (CIE) in 1931. Specifically, the chromaticity is indicated by the xy chromaticity diagram (so-called CIE chromaticity diagram) wherein three primary colors of light are digitized and represented in an xy coordinate space.

### <Sample temperature>

Blue LD light having a wavelength of 465 nm was focused to a width of 0.1 mm by means of a lens, and the optical wavelength conversion member of each sample was irradiated with the focused light. The temperature of an irradiated portion (i.e., a portion irradiated with the blue LD light) was measured by means of a radiation thermometer. The sample was irradiated with the blue LD light at a power density of 40 W/mm².

### <Refractive index ratio>

The refractive index ratios a/b and a/c of each sample were calculated from the refractive indices a and b of the dielectric films forming the dielectric multilayer film of the sample with respect to light having a wavelength of 550 nm (i.e., the refractive index a of a high-refractive-index film, and the refractive index b of a low-refractive-index film (having a refractive index lower than that of the high-refractive-index film)) and the refractive index c of the ceramic sintered body of the sample with respect to light having a wavelength of 550 nm.

The refractive index a of TiO₂, Ta₂O₅, HfO₂, ZrO₂, or Nb₂O₅ is greater than the refractive index b of SiO₂, and the refractive index a of TiO₂ is greater than the refractive index b of MgF₂.

### <Overall thickness of dielectric multilayer film>

The overall thickness of the dielectric multilayer film of each sample corresponds to the sum of the thicknesses of the dielectric films forming the dielectric multilayer film of the sample.

### <Film adhesion>

Each sample was subjected to a tape test for determining film adhesion. The test was performed according to JIS R3255, to thereby determine occurrence of exfoliation at the interface between the ceramic sintered body and the dielectric multilayer film or at the interface between the dielectric films forming the dielectric multilayer film. The film adhesion was evaluated on the basis of the following criteria: no exfoliation, partial exfoliation, and complete exfoliation.

### [8-2. Production method for sample and results of evaluation]

Next will be described a production method for each sample and the results of evaluation of the sample.

### <Experimental Example 1>

Optical wavelength conversion members (samples Nos. 1 to 4) were prepared under the conditions shown in Table 1 below.
(1) Firstly, a ceramic sintered body (fluorescent body) was prepared through the procedure described below. The dimensions of the ceramic sintered body were 10 mm (width) × 10 mm (length) × 200 µm (thickness).

Specifically, as shown in Table 1 below, Al₂O₃ powder (mean particle size: 0.2 µm) , Y₂O₃ powder (mean particle size: 1.2 µm) , and CeO₂ powder (mean particle size: 1.5 µm) were weighed in accordance with the composition of the ceramic sintered body of each of samples Nos. 1 to 4 (specifically, for the production of the ceramic sintered body having the composition of each sample).

These powder materials were added to a ball mill together with ethanol, and these materials were grind-mixed for 16 hours. The resultant slurry was dried and formed into granules. A predetermined amount (2 wt.% of total) of a completely melted binder was added to the granules, and the mixture was thoroughly stirred and dried, to thereby yield a predetermined powder.

The powder was subjected to press molding and then CIP molding, to thereby prepare a compact. The compact was degreased and then fired in an air atmosphere at a temperature of 1,600°C for 10 hours, to thereby prepare a ceramic sintered body.

Although not illustrated in Tables 1 and 2, each sample had a relative density of 99% or more (the same shall apply to other samples described below).

(2) A dielectric multilayer film and a metal layer were formed on the ceramic sintered body through the procedure described below.

Firstly, a dielectric multilayer film was formed on one surface of the ceramic sintered body. Specifically, a TiO₂ film was formed on the surface of the ceramic sintered body, and an SiO₂ film was formed on the surface of the TiO₂ film.

As shown in detail in Table 1, the dielectric multilayer film was formed of one TiO₂ film and one SiO₂ film, or two TiO₂ films and two SiO₂ films. The thickness of each film was adjusted to 25 nm or 50 nm. In sample No. 3, two TiO₂ films and two SiO₂ films were formed so that a TiO₂ film, a SiO₂ film, a TiO₂ film, and a SiO₂ film were stacked in this order.

Subsequently, as shown in Table 1 below, the surface of the dielectric multilayer film (i.e., the surface of the SiO₂ film) was coated with a reflective metal (i.e., Ag or Al), to thereby form a metal layer (i.e., an Ag layer or an Al layer). The thickness of the Ag layer or the Al layer was adjusted to 300 nm.

Thereafter, as shown in Table 1 below, an Ni layer was formed on the surface of the Ag layer or the Al layer. The thickness of the Ni layer was adjusted to 100 nm.

The Ag, Al, or Ni coating was performed by means of vacuum vapor deposition.

Thus, the optical wavelength conversion member of each sample was produced.

(3) The optical wavelength conversion member of each sample was evaluated by the aforementioned evaluation methods. The results of evaluation are shown in Table 2 below.

As shown in Table 2, samples Nos. 1 to 4 are preferred, since the samples exhibit a laser output resistance of more than 100 W/mm² and are less likely to cause temperature quenching. These samples are preferred in view that they include a dielectric multilayer film and a metal layer shown in Table 1, exhibit a refractive index ratio a/b of 2.02, a refractive index ratio a/c of 1.65, a high fluorescence intensity of 108% or more, a small color unevenness of 0.029 or less, and a low irradiated portion temperature of 128°C or less (i.e., superior heat dissipation). In addition, these samples exhibit superior film adhesion, since the overall thickness of the dielectric multilayer film is as small as 100 nm or less.

### <Experimental Example 2>

Optical wavelength conversion members (samples Nos. 5 and 6) were prepared under the conditions shown in Table 1 below.

Basically, the ceramic sintered body sample of Experimental Example 2 was prepared in the same manner as employed in Experimental Example 1.

However, in sample No. 5, Gd₂O₃ powder (mean particle size: 1.1 µm) was added, and the amount of Gd was adjusted to be 30*%* by mole relative to the amount of Y. In sample No. 7, Lu₂O₃ powder (mean particle size: 4.1 µm) and Ga₂O₃ powder (mean particle size: 0.9 µm) were added, the amount of Lu was adjusted to be 50*%* by mole relative to the amount of Y, and the amount of Ga was adjusted to be 50*%* by mole relative to the amount of Al.

In the same manner as employed in Experimental Example 1, a dielectric multilayer film and a metal coating were formed on the ceramic sintered body of Experimental Example 2 as shown in Table 1 below, to thereby produce an optical wavelength conversion member. A metal layer is formed of a metal (i.e., Al or Ag) shown at the left end in the column "Metal coating" of Table 1.

The resultant optical wavelength conversion member of each sample was evaluated by the aforementioned evaluation methods. The results of evaluation are shown in Table 2 below.

As shown in Table 2, samples Nos. 5 and 7 are preferred, since the samples exhibit a laser output resistance of more than 100 W/mm² and are less likely to cause temperature quenching. These samples are preferred in view that they include a dielectric multilayer film and a metal layer shown in Table 1, exhibit a refractive index ratio a/b of 2.02, a refractive index ratio a/c of 1.65, a high fluorescence intensity of 106% or more, a small color unevenness of 0.029, and a low irradiated portion temperature of 132°C or less. In addition, these samples exhibit superior film adhesion, since the overall thickness of the dielectric multilayer film is as small as 100 nm.

### <Experimental Example 3>

An optical wavelength conversion member (sample No. 7) was prepared under the conditions shown in Table 1 below. Sample No. 7, which includes no dielectric multilayer film, corresponds to Comparative Example.

The ceramic sintered body sample of Experimental Example 3 was prepared in the same manner as employed in Experimental Example 1.

As shown in Table 1 below, a metal coating was formed directly on the ceramic sintered body of Experimental Example 3 without formation of a dielectric multilayer film, to thereby produce an optical wavelength conversion member.

The resultant optical wavelength conversion member of each sample was evaluated by the aforementioned evaluation methods. The results of evaluation are shown in Table 2 below.

As shown in Table 2, sample No. 7 is not preferred, since the sample exhibits a low fluorescence intensity of 94% and poor film adhesion.

### <Experimental Example 4>

Optical wavelength conversion members (samples Nos. 8 and 9) were prepared under the conditions shown in Table 1 below. Samples Nos. 8 and 9 have ceramic sintered bodies different from those of samples Nos. 1 to 7.

Basically, the ceramic sintered body sample of Experimental Example 4 was prepared in the same manner as employed in Experimental Example 1.

However, in sample No. 8, the ceramic sintered body was formed of a fluorescent body prepared from a dispersion of YAG particles in glass. In sample No. 9, the ceramic sintered body was formed of a YAG single-crystal fluorescent body.

In the same manner as employed in Experimental Example 1, a dielectric multilayer film and a metal coating were formed on the ceramic sintered body of Experimental Example 4 as shown in Table 1 below, to thereby produce an optical wavelength conversion member.

The resultant optical wavelength conversion member of each sample was evaluated by the aforementioned evaluation methods. The results of evaluation are shown in Table 2 below.

As shown in Table 2, sample No. 8 is not preferred, since the sample exhibits a low laser output resistance of 40 W/mm², and a low fluorescence intensity of 90%. Sample No. 8 is not preferred in view that it exhibits a larger color unevenness and a higher irradiated portion temperature than samples Nos. 1 to 6.

Sample No. 9 is not preferred, since the sample exhibits a low laser output resistance of 75 W/mm². Sample No. 9 is not preferred in view that it exhibits a larger color unevenness and a higher irradiated portion temperature than samples Nos. 1 to 6. Sample No. 9 exhibits a fluorescence intensity of 100%, which is lower than that of samples Nos. 1 to 6.

### <Experimental Example 5>

Optical wavelength conversion members (samples Nos. 10 and 11) were prepared under the conditions shown in Table 1 below.

Basically, the ceramic sintered body sample of Experimental Example 5 was prepared in the same manner as employed in Experimental Example 1. However, the structure of a metal coating was changed.

Specifically, the ceramic sintered body of sample No. 10 or 11 was provided with an Ag or Al layer (200 nm) and an Ni layer (100 nm), and an Au or Ag layer (200 nm) was formed on the Ni layer.

In the same manner as employed in Experimental Example 1, a dielectric multilayer film and a metal coating were formed on the ceramic sintered body of Experimental Example 5 as shown in Table 1 below, to thereby produce an optical wavelength conversion member.

The resultant optical wavelength conversion member of each sample was evaluated by the aforementioned evaluation methods. The results of evaluation are shown in Table 2 below.

As shown in Table 2, samples Nos. 10 and 11 are preferred, since the samples exhibit a laser output resistance of more than 100 W/mm² and are less likely to cause temperature quenching. These samples are preferred in view that they include a dielectric multilayer film and a metal layer shown in Table 1, exhibit a refractive index ratio a/b of 2.02, a refractive index ratio a/c of 1.65, a high fluorescence intensity of 105% or more, a small color unevenness of 0.029 or less, and a low irradiated portion temperature of 126°C or less. In addition, these samples exhibit superior film adhesion, since the overall thickness of the dielectric multilayer film is as small as 100 nm.

### <Experimental Example 6>

Optical wavelength conversion members (samples Nos. 12 to 18) were prepared under the conditions shown in Table 1 below.

The ceramic sintered body sample of Experimental Example 6 was prepared in the same manner as employed in Experimental Example 1.

In the same manner as employed in Experimental Example 1, a dielectric multilayer film and a metal coating were formed on the ceramic sintered body of Experimental Example 6 as shown in Table 1 below, to thereby produce an optical wavelength conversion member.

The resultant optical wavelength conversion member of each sample was evaluated by the aforementioned evaluation methods. The results of evaluation are shown in Table 2 below.

As shown in Table 2, samples Nos. 12 to 17 are preferred, since the samples exhibit a laser output resistance of more than 100 W/mm² and are less likely to cause temperature quenching. These samples are preferred in view that they include a dielectric multilayer film and a metal coating shown in Table 1, exhibit a refractive index ratio a/b of 1.32 or more, a refractive index ratio a/c of 1.08 or more, a high fluorescence intensity of 107% or more, a small color unevenness of 0.034 or less, and a low irradiated portion temperature of 135°C or less. In addition, these samples exhibit superior film adhesion, since the overall thickness of the dielectric multilayer film is as small as 300 nm.

Sample No. 18 is not preferred, and does not form part of the invention as claimed. The sample exhibits a laser output resistance of more than 100 W/mm² and is less likely to cause temperature quenching. It includes a dielectric multilayer film and a metal coating shown in Table 1, exhibits a refractive index ratio a/b of 2.02, a refractive index ratio a/c of 1.65, and a high fluorescence intensity of 118%. Since the overall thickness of the dielectric multilayer film is 400 nm, the sample exhibits lower film adhesion than a sample including a dielectric multilayer film having an overall thickness of 300 nm.

**[Table 1]**

| | | No. | Type of fluorescent body | | | | Dielectric multilayer film | | Metal coating |
|---|---|---|---|---|---|---|---|---|---|
| | | | Al₂O₃ amount [vol%] | A₃ B₅ O₁₂ : Ce | | | | | |
| | | | | A | B | Amount [vol%] | | | |
| Examples of the present disclosure | Experimental Example 1 | 1 | 75 | Y | Al | 25 | TiO₂/50nm, SiO₂/50nm | | Ag/300nm, Ni/100nm |
| | | 2 | 75 | Y | Al | 25 | TiO₂/25nm, SiO₂/25nm | | Ag/300nm, Ni/ 100nm |
| | | 3 | 75 | Y | Al | 25 | TiO₂/25nm, SiO₂ /25nm, Two layers for each | | Ag/300nm, Ni/100nm |
| | | 4 | 75 | Y | Al | 25 | TiO₂/50nm, SiO₂/50nm | | Al/300nm, Ni/100nm |
| | Experimental Example2 | 5 | 75 | Y, Gd | Al | 25 | TiO₂/50nm, SiO₂/50nm | | Al/300nm, Ni/100nm |
| | | 6 | 75 | Y, Lu | Al, Ga | 25 | TiO₂/50nm, SiO₂/50nm | | Al/300nm, Ni/100nm |
| Comparative Examples | Experimental Example3 | 7 | 75 | Y | Al | 25 | | None | Ag/300nm, Ni/100nm |
| | Experimental Example4 | 8 | YAG powder + glass mixture | | | | TiO₂/50nm, Si0₂/50nm | | Ag/300nm, Ni/100nm |
| | | 9 | YAG single-crystal | | | | TiO₂/50nm, SiO₂/50nm | | Ag/300nm, Ni/100nm |
| Examples of the present disclosure | Experimental Examples | 10 | 75 | Y | Al | 25 | TiO₂/50nm, SiO₂/50nm | | Ag/200nm, Ni/100nm, Au/200nm |
| | | 11 | 75 | Y | Al | 25 | TiO₂/50nm, SiO₂/50nm | | Al/200nm, Ni/100nm, Ag/200nm |
| | Experimental Examples | 12 | 75 | Y | Al | 25 | Ta₂O₅/50nm, SiO₂/50nm | | Al/200nm, Ni/100nm, Ag/200nm |
| | | 13 | 75 | Y | Al | 25 | HfO₂/50nm, SiO₂/50nm | | Al/200nm, Ni/100nm, Ag/200nm |
| | | 14 | 75 | Y | Al | 25 | ZrO₂/50nm, SiO₂/50nm | | Al/200nm, Ni/100nm, Ag/200nm |
| | | 15 | 75 | Y | Al | 25 | Nb₂O₅/50nm, SiO₂/50nm | | Al/200nm, Ni/100nm, Ag/200nm |
| | | 16 | 75 | Y | Al | 25 | TiO₂/50nm, MgF₂/50nm | | Al/200nm, Ni/100nm, Ag/200nm |
| | | 17 | 75 | Y | Al | 25 | TiO₂/50nm, SiO₂/50nm, Three layers for each | | Al/200nm, Ni/100nm, Ag/200nm |
| Comparative Example | | 18 | 75 | Y | Al | 25 | TiO₂/50nm, SiO₂/50nm, Four layers for each | | Al/200nm, Ni/100nm, Ag/200nm |

**[Table 2]**

| | | No. | Laser output resistance [w/mm² ] | Fluorescence intensity [%] | Color unevennes s | Irradiation portion temperature [°C] | Refractive index ratio (a/b) | Refractive index ratio (a/c) | Overall thickness of dielectric multilayer film [nm] | Film adhesion |
|---|---|---|---|---|---|---|---|---|---|---|
| Examples of the present disclosure | Experimental Example 1 | 1 | > 100 | 120 | 0.024 | 108 | 202 | 1.65 | 100 | No exfoliation |
| | | 2 | > 100 | 123 | 0.026 | 108 | 202 | 1.65 | 50 | No exfoliation |
| | | 3 | > 100 | 115 | 0.025 | 108 | 202 | 1.65 | 100 | No exfoliation |
| | | 4 | > 100 | 108 | 0.029 | 128 | 202 | 1.65 | 100 | No exfoliation |
| | Experimental Example 2 | 5 | > 100 | 106 | 0.029 | 132 | 2.02 | 1.65 | 100 | No exfoliation |
| | | 6 | > 100 | 109 | 0.029 | 119 | 202 | 1.65 | 100 | No exfoliation |
| Comparative Examples | Experimental Example 3 | 7 | > 100 | *94* | 0.028 | 102 | < | < | 0 | Complete exfoliation |
| | Experimental Example 4 | 8 | *40* | *90* | 0.034 | 320 | 2.02 | 1.90 | 100 | No exfoliation |
| | | 9 | *75* | 100 | 0.12 | 215 | 202 | 1.61 | 100 | No exfoliation |
| Examples of the present disclosure | Experimental Example 5 | 10 | > 100 | 118 | 0.024 | 115 | 2.02 | 1.65 | 100 | No exfoliation |
| | | 11 | > 100 | 105 | 0.029 | 126 | 2.02 | 1.65 | 100 | No exfoliation |
| | Experimental Example 6 | 12 | > 100 | 107 | 0.034 | 125 | 1.48 | 121 | 100 | No exfoliation |
| | | 13 | > 100 | 108 | 0.023 | 128 | 132 | 124 | 100 | No exfoliation |
| | | 14 | > 100 | 112 | 0.024 | 129 | 1.52 | 108 | 100 | No exfoliation |
| | | 15 | > 100 | 116 | 0.032 | 130 | 1.59 | 130 | 100 | No exfoliation |
| | | 16 | > 100 | 122 | 0.024 | 126 | 2.13 | 1.65 | 100 | No exfoliation |
| | | 17 | > 100 | 118 | 0.030 | 135 | 2.02 | 165 | 300 | No exfoliation |
| Comparative **Example** | | 18 | > 100 | 118 | 0.039 | 144 | 2.02 | 165 | 400 | Partial exfoliation |

### [9. Other embodiments]

Needless to say, the present disclosure is not limited to the aforementioned embodiment, but may be implemented in various other forms without departing from the scope of the invention as defined by the appended claims.
(1) For example, a sample was prepared through firing in air in the Examples described above. However, a sample having the same performance as that of the Examples can be prepared through another firing technique, such as hot press firing, vacuum firing, firing in a reducing atmosphere, HIP, or any combination of these.
(2) The aforementioned optical wavelength conversion member or light-emitting device can be used for various applications, including fluorescent bodies, optical wavelength conversion apparatuses, head lamps, lighting apparatuses, and optical apparatuses (e.g., projectors).
(3) No particular limitation is imposed on the light-emitting element used in the light-emitting device. The light-emitting element may be any known element, such as an LED or LD.
(4) In the aforementioned embodiments, the function of a single component may be shared by a plurality of components, or a single component may exert the functions of a plurality of components. Embodiments of the present invention encompass any form specified by the appended claims.

## Claims

1. An optical wavelength conversion member (1) comprising a ceramic sintered body (3), wherein the ceramic sintered body has
a fluorescent phase containing, as a main component, fluorescent crystal grains that generate fluorescence in response to incident light, and
a translucent phase containing translucent crystal grains as a main component, wherein the optical wavelength conversion member further comprises
a metal layer (7) having light reflectivity and provided on a side of the ceramic sintered body opposite the side on which the light is incident, and
a dielectric multilayer film (5) including dielectric layers (5a, 5b) having different optical refractive indices and provided between the ceramic sintered body and the metal layer,
**characterized in that** the dielectric multilayer film has an overall thickness of 300 nm or less.

2. An optical wavelength conversion member according to claim 1, wherein the crystal grains of the fluorescent phase have a composition represented by formula A₃B₅O₁₂:Ce, and each of elements A and B is at least one element selected from the following element groups:
A: Sc, Y, and lanthanoids exclusive of Ce, and
B: Al and Ga.

3. An optical wavelength conversion member according to claim 1 or 2, wherein the crystal grains of the translucent phase have a composition of Al₂O₃.

4. An optical wavelength conversion member according to any one of claims 1 to 3, wherein the metal layer contains Ag and/or Al as a component.

5. An optical wavelength conversion member according to claim 4, further comprising an Ni layer (23) and/or an Au layer (43) provided on a side of the metal layer opposite the light incident side.

6. An optical wavelength conversion member according to any one of claims 1 to 5, wherein
the dielectric multilayer film is formed by alternate stacking of a high-refractive-index film (5a) that exhibits a refractive index "a" upon incidence of light having a wavelength of 550 nm and a low-refractive-index film (5b) that exhibits a refractive index "b" upon incidence of light having a wavelength of 550 nm, the refractive index b being lower than the refractive index a, wherein the refractive index a and the refractive index b satisfies a relation of 1.3 < a/b, and
a relation of 1 < a/c is satisfied wherein c represents the refractive index of the ceramic sintered body upon incidence of light having a wavelength of 550 nm on the ceramic sintered body.

7. An optical wavelength conversion member according to claim 6, wherein the high-refractive-index film contains at least one element selected from among Ti, Zr, Hf, Ta, and Nb, and the low-refractive-index film is formed of SiO₂ or MgF₂.

8. An optical wavelength conversion device (51) comprising an optical wavelength conversion member as recited in any one of claims 1 to 7, and a heat dissipation member joined to the metal layer of the optical wavelength conversion member on a side opposite the light incident side.

9. A light-emitting device (61) comprising an optical wavelength conversion device as recited in claim 8 and a light-emitting element (63) which emits the light.

## Patentansprüche

1. Ein optisches Wellenlängenkonversionselement (1), umfassend einen keramischen Sinterkörper (3), wobei der keramische Sinterkörper Folgendes hat
eine fluoreszierende Phase, die, als eine Hauptkomponente, fluoreszierende Kristallkörner enthält, die Fluoreszenz als Reaktion auf einfallendes Licht erzeugen, und
eine transluzente Phase, die transluzente Kristallkörner als eine Hauptkomponente enthält, wobei das optische Wellenlängenkonversionselement ferner Folgendes umfasst
eine Metallschicht (7) mit Lichtreflexion, und die auf einer Seite des keramischen Sinterkörpers gegenüber der Seite, auf der das Licht einfällt, bereitgestellt ist, und
einen dielektrischen Mehrschichtfilm (5) einschließlich dielektrischer Schichten (5a, 5b) mit unterschiedlichen optischen Brechungsindizes, und der zwischen dem keramischen Sinterkörper und der Metallschicht bereitgestellt ist,
**dadurch gekennzeichnet, dass** der dielektrische Mehrschichtfilm eine Gesamtdicke von 300 nm oder weniger hat.

2. Optisches Wellenlängenkonversionselement nach Anspruch 1, wobei die Kristallkörner der fluoreszierenden Phase eine Zusammensetzung haben, die durch Formel A₃B₅O₁₂:Ce dargestellt ist, und jedes der Elemente A und B mindestens ein Element ist, ausgewählt aus den folgenden Elementgruppen:
A: Sc, Y und Lanthanoide ausschließlich Ce, und
B: Al und Ga.

3. Optisches Wellenlängenkonversionselement nach Anspruch 1 oder 2, wobei die Kristallkörner der transluzenten Phase eine Zusammensetzung von Al₂O₃ haben.

4. Optisches Wellenlängenkonversionselement nach einem der Ansprüche 1 bis 3, wobei die Metallschicht Ag und/oder Al als eine Komponente enthält.

5. Optisches Wellenlängenkonversionselement nach Anspruch 4, ferner umfassend eine Ni-Schicht (23) und/oder eine Au-Schicht (43), die auf einer Seite der Metallschicht gegenüber der Lichteinfallsseite bereitgestellt ist.

6. Optisches Wellenlängenkonversionselement nach einem der Ansprüche 1 bis 5, wobei
der dielektrische Mehrschichtfilm gebildet ist durch abwechselndes Stapeln eines Films mit hohem Brechungsindex (5a), der einen Brechungsindex "a" beim Einfall von Licht mit einer Wellenlänge von 550 nm aufweist, und eines Films mit niedrigem Brechungsindex (5b), der einen Brechungsindex "b" beim Einfall von Licht mit einer Wellenlänge von 550 nm aufweist, wobei der Brechungsindex b niedriger als der Brechungsindex a ist, wobei der Brechungsindex a und der Brechungsindex b eine Beziehung von 1,3 < a/b erfüllen, und
eine Beziehung von 1 < a/c erfüllt ist, wobei c den Brechungsindex des keramischen Sinterkörpers beim Einfall von Licht mit einer Wellenlänge von 550 nm auf den keramischen Sinterkörper darstellt.

7. Optisches Wellenlängenkonversionselement nach Anspruch 6, wobei der Film mit hohem Brechungsindex mindestens ein Element enthält, ausgewählt aus Ti, Zr, Hf, Ta und Nb, und der Film mit niedrigem Brechungsindex aus SiO₂ oder MgF₂ gebildet ist.

8. Optische Wellenlängenkonversionsvorrichtung (51), umfassend ein optisches Wellenlängenkonversionselement nach einem der Ansprüche 1 bis 7 und ein Wärmeableitungselement, das mit der Metallschicht des optischen Wellenlängenkonversionselements auf einer Seite gegenüber der Lichteinfallsseite verbunden ist.

9. Lichtemittierende Vorrichtung (61), umfassend eine optische Wellenlängenkonversionsvorrichtung nach Anspruch 8 und ein lichtemittierendes Element (63), das das Licht emittiert.

## Revendications

1. Elément de conversion de longueur d'onde optique (1) comprenant un corps céramique fritté (3), dans lequel le corps céramique fritté a
une phase fluorescente contenant, en tant que composant principal, des grains cristallins fluorescents qui génèrent une fluorescence en réponse à la lumière incidente, et
une phase translucide contenant des grains cristallins translucides en tant que composant principal, dans lequel l'élément de conversion de longueur d'onde optique comprend en outre
une couche métallique (7) ayant une réflectivité de la lumière et disposée sur un côté du corps céramique fritté opposé au côté sur lequel la lumière est incidente, et
un film multicouche diélectrique (5) comprenant des couches diélectriques (5a, 5b) ayant des indices de réfraction optique différents et disposé entre le corps céramique fritté et la couche métallique,
**caractérisé en ce que** le film multicouche diélectrique a une épaisseur globale de 300 nm ou moins.

2. Elément de conversion de longueur d'onde optique selon la revendication 1, dans lequel les grains cristallins de la phase fluorescente ont une composition représentée par la formule A₃B₅O₁₂:Ce, et chacun des éléments A et B est au moins un élément choisi parmi les groupes d'éléments suivants :
A : Sc, Y et lanthanoïdes à l'exclusion de Ce et
B : Al et Ga.

3. Elément de conversion de longueur d'onde optique selon la revendication 1 ou 2, dans lequel les grains cristallins de la phase translucide ont une composition de Al₂O₃.

4. Elément de conversion de longueur d'onde optique selon l'une quelconque des revendications 1 à 3, dans lequel la couche métallique contient Ag et/ou Al en tant que composant.

5. Elément de conversion de longueur d'onde optique selon la revendication 4, comprenant en outre une couche Ni (23) et/ou une couche Au (43) prévue sur un côté de la couche métallique opposé au côté incident de lumière.

6. Elément de conversion de longueur d'onde optique selon l'une quelconque des revendications 1 à 5, dans lequel
le film multicouche diélectrique est formé par empilement alterné d'un film à indice de réfraction élevé (5a) qui présente un indice de réfraction « a » lors de l'incidence de la lumière ayant une longueur d'onde de 550 nm et un film à faible indice de réfraction (5b) qui présente un indice de réfraction « b » lors de l'incidence de la lumière ayant une longueur d'onde de 550 nm, l'indice de réfraction b étant inférieur à l'indice de réfraction a, dans lequel l'indice de réfraction a et l'indice de réfraction b satisfont une relation de 1,3 < a/b, et une relation de 1 < a/c est satisfaite dans laquelle c représente l'indice de réfraction du corps céramique fritté lors de l'incidence de la lumière ayant une longueur d'onde de 550 nm sur le corps céramique fritté.

7. Elément de conversion de longueur d'onde optique selon la revendication 6, dans lequel le film à indice de réfraction élevé contient au moins un élément choisi parmi Ti, Zr, Hf, Ta et Nb, et le film à indice de réfraction bas est formé de SiO₂ ou MgF₂.

8. Dispositif de conversion de longueur d'onde optique (51) comprenant un élément de conversion de longueur d'onde optique selon l'une quelconque des revendications 1 à 7, et un élément de dissipation thermique relié à la couche métallique de l'élément de conversion de longueur d'onde optique sur un côté opposé au côté de la lumière incidente.

9. Dispositif électroluminescent (61) comprenant un dispositif de conversion de longueur d'onde optique selon la revendication 8 et un élément électroluminescent (63) qui émet la lumière.
